(19) Europäisches Patentamt
European Patent Office
Office européen des brevets

(11) **EP 1 912 076 A2**

(12) **EUROPÄISCHE PATENTANMELDUNG**

(43) Veröffentlichungstag:
**16.04.2008 Patentblatt 2008/16**

(51) Int Cl.:
*G01R 31/26* (2006.01)  *H01L 31/18* (2006.01)

(21) Anmeldenummer: **07118372.7**

(22) Anmeldetag: **12.10.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK RS**

(30) Priorität: **13.10.2006 DE 102006049683**

(71) Anmelder: **Q-Cells AG**
**06766 Thalheim (DE)**

(72) Erfinder:
• **Dr. Müller, Jörg**
**06792, Sandersdorf (DE)**

• **Dr. Isenberg, Jörg**
**04317, Leipzig (DE)**
• **Suthues, Jörn**
**04105, Leipzig (DE)**
• **Bivour, Martin**
**12623, Berlin (DE)**
• **Rakotoniaina, Jean Patrice**
**06108, Halle/Saale (DE)**

(74) Vertreter: **Müller, Wolfram Hubertus**
**Patentanwälte**
**Maikowski & Ninnemann**
**Postfach 15 09 20**
**10671 Berlin (DE)**

(54) **Verfahren und Vorrichtung zum Charakterisieren von Wafern bei der Herstellung von Solarzellen**

(57)     Die Erfindung betrifft ein Verfahren zum Charakterisieren von Wafern bei der Herstellung von Solarzellen, mit den Schritten:

a) Bereitstellen eines Wafers und Durchführen eines Herstellungsprozesses mit dem Wafer zum Herstellen einer Solarzelle oder mehrerer Solarzellen;

b) während des Herstellungsprozesses Durchführen eines Nasschemieschrittes mit dem Wafer, wobei der Nasschemieschritt einen Einfluss der Waferoberfläche auf die Lebensdauer von Ladungsträgern in dem Wafer verringert;

c) während des Nasschemieschrittes oder nach dem Nasschemieschritt Bestrahlen des Wafers mit Licht zum Erzeugen Ladungsträger in dem Wafer;

d) Bestimmen der Lebensdauer der in Schritt c) erzeugten Ladungsträger; und

e) Charakterisieren des Wafers anhand der in Schritt d) bestimmten Lebensdauer.

In einem zweiten Aspekt betrifft die Erfindung eine Vorrichtung zum Charakterisieren von Wafern bei der Herstellung von Solarzellen.

## FIG 1

**EP 1 912 076 A2**

**Beschreibung**

Die Erfindung betrifft ein Verfahren und eine Vorrichtung zum Charakterisieren von Wafern bei der Herstellung von Solarzellen gemäß dem Oberbegriff des Anspruchs 1 bzw. 19.

Bekanntermaßen weist eine Solarzelle ein Halbleitermaterial auf, in dem Sonnenlicht durch optische Absorption in elektrischen Strom umgesetzt wird. Bei der Herstellung von Solarzellen werden Halbleiter-Wafer eingesetzt, aus denen in einem Herstellungsprozess jeweils eine Solarzelle oder mehrere Solarzellen hergestellt werden. Ein Kriterium für die Qualität der für die Solarzellenherstellung verwendeten Wafer ist insbesondere die Lebensdauer durch Lichtabsorption in dem Wafer erzeugter Ladungsträger.

Die Lebensdauer ist ein Maß für die Zeitspanne, die vergeht, bis ein erzeugter Ladungsträger in seinen energetischen Ausgangszustand zurückkehrt (rekombiniert). Somit ist bei Verwendung eines Wafers mit einer hohen Ladungsträger-Lebensdauer für die Solarzellen-Herstellung grundsätzlich ein höherer Wirkungsgrad zu erwarten.

Als Ausgangsmaterial für Solarzellen wird üblicherweise Silizium verwendet. Die Lebensdauer durch Lichteinwirkung erzeugter Ladungsträger ist in Silizium dominiert durch Rekombinationen der Ladungsträger über Energiezustände, die auf Fremdatome (d.h. Verunreinigungen) oder auf Kristalldefekte zurückgehen. In einem Wafer mit wenig Verunreinigungen bzw. Kristalldefekten werden generierte Ladungsträger eine größere Lebensdauer aufweisen, da weniger Rekombinationszentren vorhanden sind.

Eine Schwierigkeit bei der Qualitätsbeurteilung eines Wafers anhand einer Lebensdauermessung ist, dass die Lebensdauer im Wafer erzeugter Ladungsträger durch Rekombination über Oberflächenzustände beeinflusst ist. Besonders bei dünnen Wafern wird die messbare Lebensdauer durch den Oberflächeneinfluss dominiert, so dass die Bestimmung der Lebensdauer hauptsächlich eine Aussage über die Oberfläche des Wafers liefern würde. Für eine Qualitätsbeurteilung eines Wafers anhand der Lebensdauer ist jedoch die Lebensdauer der im Volumen des Wafers erzeugten Ladungsträger ausschlaggebend.

Messtechnisch zugänglich ist nur eine effektive Gesamt-Lebensdauer, die sowohl einen Beitrag der Oberflächenrekombination (mit einer korrespondierenden Rekombinationszeit $\tau_s$) und als auch einen Beitrag einer Rekombination im Volumen des Wafers (mit Rekombinationszeit $\tau_{bulk}$) abhängt. Für die effektive Lebensdauer $\tau_{eff}$ gilt:

$$\frac{1}{\tau_{eff}} = \frac{1}{\tau_S} + \frac{1}{\tau_{bulk}}$$

Daher müssen zur Qualitätsbestimmung eines Wafer per Lebensdauermessung Oberflächeneffekte reduziert bzw. möglichst eliminiert werden. Für die Oberflächenrekombinationszeit $\tau_s$ spielt neben der Waferdicke W die Oberflächenrekombinationsgeschwindigkeit S eine Rolle. Insbesondere gilt die Abschätzung (für den Fall, dass S < D/4W):

$$\frac{1}{\tau_S} = \frac{2S}{W}$$

Eine Möglichkeit, Oberflächeneffekte (d.h. die Oberflächenrekombinationsgeschwindigkeit S) zu reduzieren, besteht darin, die Waferoberfläche mit einer Passivierung in Form einer dielektrischen Beschichtung (z. B. aus Oxid, Nitrid oder einem Polymer) zu versehen. Hierdurch wird die Anzahl der Oberflächenzustände reduziert und/oder eine Bandverbiegung an der Oberfläche induziert, wodurch die Geschwindigkeit der Rekombination über Oberflächenzustände herabgesetzt wird.

Das von der vorliegenden Erfindung zu lösende Problem besteht darin, eine genauere Bestimmung der Waferqualität während der Solarzellen-Herstellung mittels Lebensdauermessung als bisher zu ermöglichen.

Dieses Problem wird durch das Verfahren mit den Merkmalen gemäß dem Anspruch 1 sowie durch die Vorrichtung mit den Merkmalen gemäß dem Anspruch 19 gelöst. Besonders bevorzugte und vorteilhafte Weiterbildungen der Erfindung sind in den Unteransprüchen angegeben.

Danach ist ein Verfahren zum Charakterisieren von Wafern bei der Herstellung von Solarzellen gegeben, das die Schritte aufweist:

a) Bereitstellen eines Wafers und Durchführen eines Herstellungsprozesses mit dem Wafer zum Herstellen einer oder mehrerer Solarzellen;

b) während des Herstellungsprozesses Durchführen eines Nasschemieschrittes mit dem Wafer, wobei der Nasschemieschritt einen Einfluss der Waferoberfläche auf die Lebensdauer von Ladungsträgern in dem Wafer verringert;

c) während des Nasschemieschrittes oder nach dem Nasschemieschritt Bestrahlen des Wafers mit Licht zum Erzeugen von Ladungsträgern in dem Wafer;

d) Bestimmen der Lebensdauer der in Schritt c) erzeugten Ladungsträger; und

e) Charakterisieren des Wafers anhand der in Schritt d) bestimmten Lebensdauer.

Dieses Verfahren vermeidet eine aufwändige Passivierung, wie zum Beispiel das Erzeugen einer Oxidschicht an der Waferoberfläche durch thermische Oxidation oder Aufbringen einer Siliziumnitrid-Beschichtung auf die Oberfläche vor der Lebensdauermessung. Die Passivierung (d.h. die Reduzierung der Oberflächenzustände bzw. allgemein die Reduzierung des Oberflächeneinflusses) des Wafers erfolgt ausschließlich über den Nasschemieschritt.

Die Möglichkeit, eine ausreichende Oberflächenpassivierung durch einen Nasschemieschritt zu erzeugen, wird von der vorliegenden Erfindung ausgenutzt, um vor einer Lebensdauerbestimmung im Herstellungsprozess eine Passivierung des Wafers vorzunehmen, wodurch eine genauere Beurteilung der Waferqualität anhand der Lebensdauermessung als bisher möglicht ist. Bei der Erfindung erfolgt sowohl die Passivierung (durch den Nasschemieschritt) als auch das Bestimmen der Lebensdauer im Herstellungsprozess, also "in-line".

Dabei kann der Nasschemieschritt sowohl einen Ätzschritt als auch einen Reinigungsschritt umfassen. Besonders bevorzugt erfolgt der Nasschemieschritt als Ätzung unter Verwendung einer sauren Ätzlösung. Dabei kann insbesondere Flusssäure als Ätzlösung verwendet werden, bevorzugt in schwächeren Konzentrationen (z. B. Konzentrationen unterhalb von fünf Volumenprozent, wodurch der Umgang mit der Flusssäure sicherer und somit die Handhabung der Säure vereinfacht wird). Für den Nasschemieschritt können jedoch auch andere Lösungen verwendet werden, z.B. eine Jod-EthanolLösung.

Der Nasschemieschritt kann als zusätzlicher Ätzschritt vorgesehen sein, ist aber bevorzugt ein ohnehin im Herstellungsprozess vorhandener Nasschemieschritt. Zum Beispiel kann es sich um die am Beginn eines herkömmlichen Solarzellen-Herstellungsprozesses durchzuführende Sägeschadenätzung handeln. Dabei kann das Bestimmen der Lebensdauer während der Ätzung (zum Beispiel während sich der Wafer noch im Bekken befindet) oder anschließend an die Ätzung durchgeführt werden. Eine Lebensdauerbestimmung direkt während oder unmittelbar nach der Sägeschadenätzung hat den Vorteil, dass Material mit geringer Lebensdauer (d.h. mit schlechter Qualität) bereits am Anfang des Herstellungsprozesses aussortiert werden kann.

Eine andere Möglichkeit, einen üblicherweise ohnehin im Herstellungsprozess für Solarzellen vorhandenen Ätzschritt zur Oberflächenpassivierung zu verwenden, besteht darin, die Lebensdauermessung während oder im Anschluss an ein Reinigungsätzen nach einer POCI-Diffusion (Diffusion mit $POCl_3$) durchzuführen. Erfolgt die Lebensdauermessung nach diesem Schritt zusätzlich (z.B. zusätzlich zu einer beim Sägenschadenätzen bereits durchgeführten Messung), ließe sich die Qualitätsveränderung des Wafer-Materials durch den POCI-Prozessschritt kontrollieren.

Grundsätzlich kann die Bestimmung der Lebensdauer wie erwähnt erfolgen, während sich der Wafer noch in der Passivierungs-Ätzlösung befindet. Der Wafer kann zur Messung der Lebensdauer jedoch auch aus der Ätzlösung entfernt werden. Es ist jedoch nicht unbedingt erforderlich, die Lebensdauermessung unmittelbar nach dem Herausnehmen des Wafers aus der Passivierungs-Ätzlösung vorzunehmen. Es können zwischen der Herausnahme aus der Ätzlösung und der Lebensdauermessung zum Beispiel Spül- oder Reinigungsschritte liegen.

Hier steht ein bestimmtes Zeitintervall für die Lebensdauer-Bestimmung zur Verfügung, in dem die Passivierungswirkung der Ätzlösung nach Herausnahme des Wafers aus der Ätzlösung anhält.

In einer besonders bevorzugten Ausführung der Erfindung erfolgt das Bestrahlen des Wafers mit einem Lichtpuls, der zum Beispiel von einer Blitzlampe, einer LED-Vorrichtung oder einem Laser erzeugt werden kann. Der Lichtpuls erzeugt in dem Wafer Ladungsträger bzw. eine Ladungsträgerdichte, deren Abklingen gemessen wird, um die Lebensdauer der erzeugten Ladungsträger zu bestimmen.

Grundsätzlich sind zum Messen der Lebensdauern von in Solar-Wafern erzeugten Ladungsträgern verschiedene Verfahren bekannt. In der vorliegenden Erfindung wird bevorzugt das an sich bekannte QSSPC (Quasi Steady State Photo Conductance) - Verfahren verwendet, vgl. R.A. Sinton, A. Cuevas, "Contactless determination of currentvoltage characteristics and minority-carrier lifetimes in semiconductors from quassteady-state photoconductance data", Appl. Phys. Lett. 69(17), S. 2510, 1996.

Bei diesem Verfahren wird der zu charakterisierende Wafer induktiv über eine Spule an einen Schwingkreis angekoppelt und mit einem Lichtpuls angeregt. Während des Lichtpulses wird die Spannung im Schwingkreis bestimmt, wobei die Spannung im Schwingkreis von der Leitfähigkeit des Wafers abhängt. Über die Leitfähigkeit des Wafers wiederum ist die Lebensdauer der durch den Lichtpuls im Wafer erzeugten Ladungsträger bestimmbar.

Der Vorteil der QSSPC-Methode ist, dass die Messung mit einer sehr hohen Geschwindigkeit durchgeführt werden kann, so dass im Herstellungsprozess die Taktzeit (und damit der Durchsatz) der Solarzellenproduktion nicht verringert werden muss. Wie erwähnt, existieren weitere Methoden zur Lebensdauerbestimmung, die prinzipiell ebenfalls im Rahmen der Erfindung eingesetzt werden können, insbesondere zählen dazu auch Methoden, die eine ortsaufgelöste Messung der Lebensdauer über den Wafer hinweg erlauben, beispielsweise mittels MW-PCD (microwave-detected photoconductance decay), PL (Photolumineszenz) oder CDI-ILM (carrier density imaging - infrared camera lifetime mapping).

Bei einer ortsaufgelösten Messung erfolgt die Lebensdauerbestimmung an verschiedenen Stellen des Wafers. Hier können z.B. einige ausgewählte Punkte der Waferoberfläche ausgemessen werden. Es kann jedoch auch ein dichteres Netz von Punkten der Waferoberfläche abgescannt werden, je nach Ortsauflösung des verwendeten Messverfahrens.

In einem zweiten Aspekt der Erfindung wird eine Vorrichtung zum Charakterisieren von Wafern bei der Herstellung von Solarzellen zur Verfügung gestellt, die einen Behälter zum Aufnehmen von Nasschemie (z.B. eines Ätz- oder Spülmittels) aufweist, in den ein Wafer zum Durchführen eines Nassätz- oder Reinigungsschrittes eingebracht werden kann.

Des Weiteren weist die Vorrichtung eine Lichtquelle auf, die so in Bezug zu dem Behälter angeordnet ist, dass mit dem Licht der Lichtquelle Ladungsträger in einem Wafer erzeugbar sind, der sich während eines Nassätz- oder Reinigungsschrittes in dem Behälter befindet. Zusätzlich sind Messmittel zum Bestimmen der Lebensdauer von mittels der Lichtquelle in einem Wafer erzeugten Ladungsträgern angeordnet.

Die erfindungsgemäße Vorrichtung ist so ausgestaltet, dass sie innerhalb einer Produktionslinie zur Herstellung von Solarzellen eingesetzt werden kann und ermöglicht somit die Integration einer aussagekräftigen Qualitätskontrolle per Lebensdauermessung in einen automatisierten Herstellungsprozess für Solarzellen.

Die Lichtquelle kann insbesondere Lichtpulse erzeugen und zum Beispiel eine Blitzlampe, eine LED-Anordnung oder ein gepulster Laser sein. Die Lichtquelle ist so relativ zum Becken angeordnet, dass sie einen im Becken befindlichen Wafer beleuchten kann. Dabei kann in dem Becken ein Ätzschritt oder ein Reinigungsschritt durchgeführt werden.

Wie bereits weiter oben mit Bezug auf das erfindungsgemäße Verfahren beschrieben, kann der Ätzschritt ein zusätzlicher Passivierungsschritt oder ein im normalen Herstellungsprozess für Solarzellen ohnehin vorhandener Ätzschritt sein. Entsprechend kann auch ein mit dem Becken durchzuführender Reinigungsschritt ein zusätzlicher im Hinblick auf die Lebensdauermessung eingeführter Reinigungsschritt (z.B. unter Verwendung von Wasser bzw. DI-Wasser) sein; oder es handelt sich um einen Reinigungsschritt, der ohnehin im normalen Herstellungsprozess vorhanden ist.

Insbesondere sind die Messmittel zur Durchführung eines an sich bekannten Messverfahrens zur Lebensdauerbestimmung ausgebildet. Wie oben bereits erwähnt, erfolgt die Lebensdauermessung bevorzugt über das QSSPC-Verfahren. Dazu können die Messmittel einen elektromagnetischen Schwingkreis mit einer Induktivität umfassen, über die ein Wafer, der sich während eines Nassätz- oder Reinigungsschrittes in dem Behälter befindet, an den elektromagnetischen Schwingkreis ankoppelbar ist. Dabei ist die Leitfähigkeit des Wafers und somit die Lebensdauer von Ladungsträgern im Wafer über die Spannung im Schwingkreis bestimmbar. Als Induktivität wird insbesondere eine am Behälter angeordnete Spule verwendet, die bevorzugt einen Innendurchmesser von näherungsweise 8 cm aufweist.

Zur Steuerung der Messung und der Lichtquelle zum Erzeugen von Ladungsträgern in dem zu charakterisierenden Wafer ist eine Steuereinheit vorgesehen. Dies kann zum Beispiel ein Rechner sein, der die Lichtquelle ansteuert und gleichzeitig die Spannung im Schwingkreis während des Lichtpulses erfasst (bei Verwendung des QSSPC-Verfahrens).

Eine besonders bevorzugte Ausgestaltung der Vorrichtung sieht zusätzlich Transportmittel (zum Beispiel ein Laufband) vor, mit denen ein Wafer (automatisch) zu dem Behälter zum Aufnehmen eines Nassätz- oder eines Spülmittels bewegt werden kann.

Die vorliegende Erfindung wird im Folgenden anhand von Ausführungsbeispielen unter Bezugnahme auf die Figuren näher erläutert. Es zeigen:

Fig. 1 schematisch eine Vorrichtung zur Bestimmung der Lebensdauer in einem Wafer während eines Solarzellen-Herstellungsprozesses;

Fig. 2 ein Flussdiagramm, das den Ablauf einer Lebensdauermessung darstellt.

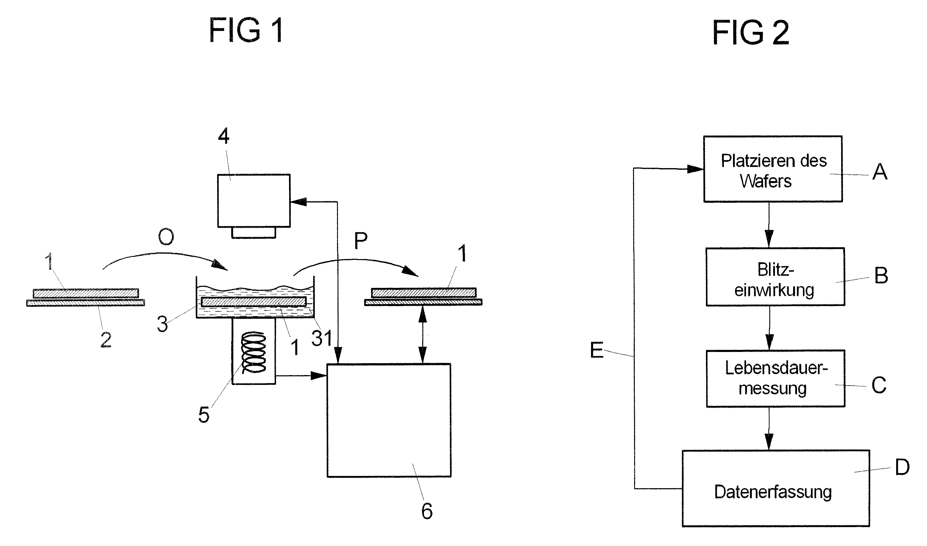

Die Figur 1 zeigt schematisch eine Vorrichtung zur Messung der Lebensdauer während der Herstellung von Solarzellen sowie den Ablauf der Lebensdauermessung. Die Vorrichtung umfasst ein Becken 3, das mit einer Ätz- oder Reinigungslösung 31 zum Durchführen eines Ätz- oder Reinigungsschrittes befüllt ist. Ein im Herstellungsprozess befindlicher Wafer 1 wird mittels eines Transportsystems 2 dem Becken 3 zugeführt (Pfeil O) bzw. von dem Becken 3 abtransportiert (Pfeil P). Neben dem automatisierten Transportieren des Wafers 1 kann zusätzlich eine Vorrichtung vorhanden sein (nicht dargestellt), mit der der Wafer automatisch in die Ätz- oder Reinigungslösung eingebracht werden kann.

Oberhalb des Beckens 3 ist eine Blitzlampe 4 angeordnet. Mit der Blitzlampe 4 ist ein Lichtpuls erzeugbar, der in einem im Becken 3 befindlichen Wafer 1 Ladungsträger generiert, deren Lebensdauer zur Bestimmung der Waferqualität gemessen werden soll. Für die Lebensdauermessung (nach dem QSSPC-Verfahren) ist unterhalb des Beckens 3 eine Induktivität in Form einer Spule 5 angeordnet.

Über die Spule 5 kann der im Becken 3 befindliche Wafer 1 an einen Schwingkreis (nicht dargestellt) angekoppelt werden. Mittels einer mit der Spule 5 und dem Schwingkreis verbundenen Steuer- und Auswerteinheit 6 wird die Spannung im Schwingkreis gemessen, worüber die Leitfähigkeit (und damit die Lebensdauer der im Wafer vorhandenen Ladungsträger) des noch im Becken 3 befindlichen Wafers bestimmt werden kann.

Gleichzeitig steuert die Einheit 6 auch die Blitzlampe 4, so dass das Anregen von Ladungsträger in dem Wafer (über den Lichtpuls) und das nachfolgende Bestimmen der Lebensdauer der erzeugten Ladungsträger synchronisiert ablaufen.

Zusätzlich kann die Einheit 6 auch die Steuerung des Transportsystems 2 übernehmen bzw. unterstützen, so dass das Heranführen von im Herstellungsprozess befindlichen Wafern an das Becken 3 im Takt mit der Lebensdauermessung erfolgen kann.

Die Figur 2 zeigt den Ablauf einer Lebensdauermessung während eines Solarzellen-Herstellungsprozesses (In-Line-Messung). Zunächst wird der Wafer in Bezug auf eine Lichtquelle platziert (Schritt A). Nach korrekter Platzierung des Wafers (bevorzugt wie in Figur 1 gezeigt in einem Ätz- bzw. einem Spülbecken) wird der Wafer mit einem Lichtblitz bestrahlt, wodurch im Wafer Ladungsträger erzeugt werden (Schritt B).

Anschließend erfolgt gemäß Schritt C die Messung der Lebensdauer der erzeugten Ladungsträger. Anschließend werden die gemessenen Daten (d.h. die Lebensdauer) gemäß Schritt D erfasst. Zusätzlich kann neben dem Erfassen ein Vergleichen der Lebensdauer-Daten mit Vergleichsdaten erfolgen, so dass eine unmittelbare Qualitätsbeurteilung des Wafers möglich ist.

Hierdurch können Wafer mit zu schlechter Qualität direkt aus dem Herstellungsprozess herausgenommen werden, was zur Kostenersparnis beiträgt, da ein komplettes Prozessieren von Wafern mit schlechter Qualität vermieden wird. Nach der Datenerfassung wird gemäß dem Pfeil E der nächste Wafer an die Messvorrichtung herangeführt.

In einer alternativen Ausgestaltung erfolgt die Lebensdauermessung ortsaufgelöst, d.h. an verschiedenen Stellen des Wafers. Hier kann ein selektives Aussortieren von einzelnen Bauelementen (Solarzellen) nach Prozessende erfolgen, die in Waferregionen mit zu geringer Lebensdauer gebildet wurden. Natürlich kann auch ein kompletter Wafer bereits vor dem Prozessende aus dem Prozess herausgenommen werden, wenn er zu viele Bereiche mit geringer Lebensdauer aufweist.

**Bezugszeichenliste**

1    Wafer
2    Transportband
3    Becken
31   Ätz- oder Reinigungslösung
4    Blitzlampe
5    Spule
6    Steuereinheit

**Patentansprüche**

1. Verfahren zum Charakterisieren von Wafern bei der Herstellung von Solarzellen, mit den Schritten:

a) Bereitstellen eines Wafers (1) und Durchführen eines Herstellungsprozesses mit dem Wafer (1) zum Herstellen einer Solarzelle oder mehrerer Solarzellen;
b) während des Herstellungsprozesses Durchführen eines Nasschemieschrittes mit dem Wafer (1), wobei der Nasschemieschritt einen Einfluss der Waferoberfläche auf die Lebensdauer von Ladungsträgern in dem Wafer (1) verringert;
c) während des Nasschemieschrittes oder nach dem Nasschemieschritt Bestrahlen des Wafers (1) mit Licht zum Erzeugen von Ladungsträgern in dem Wafer (1);
d) Bestimmen der Lebensdauer der in Schritt c) erzeugten Ladungsträger; und
e) Charakterisieren des Wafers (1) anhand der in Schritt d) bestimmten Lebensdauer.

2. Verfahren nach Anspruch 1, **dadurch gekennzeichnet, dass** der Nasschemieschritt einen Ätz- oder einen Reinigungsschritt umfasst.

3. Verfahren nach Anspruch 1 oder 2, **dadurch gekennzeichnet, dass** der Nasschemieschritt unter Verwendung einer sauren Ätzlösung (31) erfolgt.

4. Verfahren nach Anspruch 3, **dadurch gekennzeichnet, dass** der Nasschemieschritt unter Verwendung von Flusssäure erfolgt.

5. Verfahren nach Anspruch 4, **dadurch gekennzeichnet, dass** die Flusssäure eine Konzentration aufweist, die 5 Volumenprozent nicht übersteigt.

6. Verfahren nach einem der vorhergehenden Ansprüche, **dadurch gekennzeichnet, dass** der Nasschemieschritt gemäß Schritt b) gleichzeitig ein Ätz-oder ein Reinigungsschritt des Herstellungsprozesses ist.

7. Verfahren nach Anspruch 6, **dadurch gekennzeichnet, dass** der Herstellungsprozess am Beginn einen Sägeschadenätzschritt aufweist, der gleichzeitig der Nasschemieschritt gemäß Schritt b) ist.

8. Verfahren nach Anspruch 6, **dadurch gekennzeichnet, dass** der Herstellungsprozess einen Diffusionsschritt zum Dotieren des Wafers umfasst und ein nach dem Diffusionsschritt erfolgender Reinigungsschritt gleichzeitig der Nasschemieschritt gemäß Schritt b) ist.

9. Verfahren nach Anspruch 8, **dadurch gekennzeichnet, dass** der Diffusionsschritt das Diffundieren mit $POCl_3$ (POCL-Diffusion) umfasst.

10. Verfahren nach einem der vorhergehenden Ansprüche, **dadurch gekennzeichnet, dass** der Nasschemieschritt durch Einbringen des Wafers (1) in eine Ätz- oder Spüllösung (31) erfolgt.

11. Verfahren nach Anspruch 10, **dadurch gekennzeichnet, dass** der Wafer (1) zum Bestimmen der Lebensdauer aus der Ätz- bzw. Spüllösung (31) entfernt wird.

**12.** Verfahren nach Anspruch 11, **dadurch gekennzeichnet, dass** der Wafer (1) in eine Ätzlösung (31) eingebracht wird und das Bestimmen der Lebensdauer erfolgt, ohne dass nach dem Entfernen des Wafers (1) aus der Ätzlösung (31) ein Spül- oder Reinigungsschritt durchgeführt wird.

**13.** Verfahren nach Anspruch 10, **dadurch gekennzeichnet, dass** der Wafer (1) während des Bestimmens der Lebensdauer in der Ätz- oder Spüllösung (31) verbleibt.

**14.** Verfahren nach Anspruch 11, **dadurch gekennzeichnet, dass** vor dem Bestimmen der Lebensdauer mindestens ein Spül- und/oder Reinigungsschritt erfolgt.

**15.** Verfahren nach einem der vorhergehenden Ansprüche, **dadurch gekennzeichnet, dass** das Bestrahlen des Wafers (1) mit einem Lichtpuls, insbesondere einer Blitzlampe (4), einer LED-Vorrichtung oder eines Lasers, erfolgt.

**16.** Verfahren nach Anspruch 15, **dadurch gekennzeichnet, dass** zum Bestimmen der Lebensdauer

- der Wafer (1) induktiv über eine Spule (5) an einen Schwingkreis angekoppelt wird, und
- während des Lichtpulses die von der Leitfähigkeit des Wafers (1) abhängige Spannung im Schwingkreis bestimmt wird, wobei über die Leitfähigkeit die Lebensdauer der durch den Lichtpuls im Wafer (1) erzeugten Ladungsträger bestimmbar ist.

**17.** Verfahren nach Anspruch 16, **dadurch gekennzeichnet, dass** neben dem Wafer (1) gleichzeitig eine Referenzprobe, für die die Lebensdauer von durch Lichteinwirkung in ihr erzeugbaren Ladungsträgern bekannt ist, mit dem Lichtpuls bestrahlt wird.

**18.** Verfahren nach einem der vorhergehenden Ansprüche, **dadurch gekennzeichnet, dass** das Bestimmen der Lebensdauer an verschiedenen Stellen des Wafers (1) durchgeführt wird.

**19.** Vorrichtung zum Charakterisieren von Wafern bei der Herstellung von Solarzellen mit

- einem Behälter (3) zum Aufnehmen von Nasschemie, in den ein Wafer (1) zum Durchführen eines Nasschemieschrittes eingebracht werden kann;
- einer Lichtquelle (4), die so in Bezug zu dem Behälter (3) angeordnet ist, dass mit dem Licht der Lichtquelle (4) Ladungsträger in einem Wafer (1) erzeugbar sind, der sich während eines Nasschemieschrittes in dem Behälter (3) befindet; und
- Messmitteln zum Bestimmen der Lebensdauer von mittels der Lichtquelle (4) in einem in dem Behälter (3) befindlichen Wafer (1) erzeugten Ladungsträgern.

**20.** Vorrichtung nach Anspruch 19, **dadurch gekennzeichnet, dass** die Lichtquelle (4) Lichtpulse erzeugt.

**21.** Vorrichtung nach Anspruch 20, **dadurch gekennzeichnet, dass** die Lichtquelle (4) eine Blitzlampe, eine LED-Anordnung oder ein Laser ist.

**22.** Vorrichtung nach einem der Ansprüche 20 bis 21, **dadurch gekennzeichnet, dass** die Messmittel einen elektromagnetischen Schwingkreis mit einer Induktivität umfassen, über die ein Wafer (1), der sich während eines Nasschemieschrittes in dem Behälter (3) befindet, an den elektromagnetischen Schwingkreis ankoppelbar ist, wobei die Leitfähigkeit des Wafers (1) und somit die Lebensdauer durch einen Lichtpuls erzeugter Ladungsträger in dem Wafer (1) über die Spannung im Schwingkreis bestimmbar ist.

**23.** Vorrichtung nach Anspruch 22, **gekennzeichnet durch** eine derart in Bezug zu dem Behälter (31) angeordnete Spule (5) als Induktivität, dass ein Wafer (1), der sich während eines Nasschemieschrittes in dem Behälter (31) befindet, über die Spule (5) an den elektromagnetischen Schwingkreis ankoppelbar ist.

**24.** Vorrichtung nach Anspruch 23, **dadurch gekennzeichnet, dass** Spule (5) einen Durchmesser von näherungsweise 8 cm aufweist.

**25.** Vorrichtung nach einem der Ansprüche 20 bis 24, **gekennzeichnet durch** eine Steuereinheit (6) zum Ansteuern der Lichtquelle (4) und zum Erfassen der Spannung im Schwingkreis während des Lichtpulses.

**26.** Vorrichtung nach einem der Ansprüche 20 bis 25, **gekennzeichnet durch** Transportmittel (2), mit denen einen Wafer (1) zu dem Behälter (3) bewegt werden kann.

**27.** Produktionsanordnung zum Herstellen von Solarzellen mit einer Vorrichtung gemäß einem der Ansprüche 19 bis 26.

# FIG 2

Platzieren des Wafers — A

Blitz-einwirkung — B

Lebensdauer-messung — C

Datenerfassung — D

E

# FIG 1

O · P · 1 · 2 · 3 · 4 · 5 · 6 · 1 · 31 · 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **R.A. SINTON ; A. CUEVAS.** Contactless determination of currentvoltage characteristics and minority-carrier lifetimes in semiconductors from quassteady-state photoconductance data. *Appl. Phys. Lett.,* 1996, vol. 69 (17), 2510